# EUROPEAN PATENT APPLICATION

(11) **EP 4 379 449 A1**
(43) Date of publication of application: **05.06.2024**
(21) Application number: 22863186.7
(22) Date of filing: 19.08.2022
(51) Int. Cl.: G02B 26/10, G02B 26/08

(54) **DRIVING ASSEMBLY AND RELATED DEVICE**

(30) Priority: 31.08.2021 CN 202111017237
(71) Applicant: Huawei Technologies Co., Ltd., Shenzhen, Guangdong 518129 (CN)
(72) Inventor: SUN, Fengpei, Shenzhen, Guangdong 518129 (CN); FENG, Zhihong, Shenzhen, Guangdong 518129 (CN); XU, Jinghui, Shenzhen, Guangdong 518129 (CN); DONG, Xiaoshi, Shenzhen, Guangdong 518129 (CN); SUN, Jianbo, Shenzhen, Guangdong 518129 (CN)
(74) Representative: Isarpatent
(86) International application number: PCT/CN2022/113658
(87) International publication number: WO 2023/030047

(57) **Abstract**

An actuating member and a related device are provided, and may be applied to an optical communication scenario such as OXC, VOA, or WSS, or the field of projection display. A first fastening structure (11), a second fastening structure (12), and a third fastening structure (13) are fastened to a substrate. A rotating frame (40) is connected to the first fastening structure (11) by using a first cantilever beam (21), and a first comb (31) is formed on the rotating frame (40). The first comb (31) is arranged in a staggered manner with a second comb (32), and the second comb (32) is formed on the second fastening structure (12). A rotating platform (60) is located at an inner side of the rotating frame (40), the rotating platform (60) is connected to the rotating frame (40) by using a second cantilever beam (22), and a third comb (33) is formed on the rotating platform (60). The third comb (33) is arranged in a staggered manner with a fourth comb (34), the fourth comb (34) is formed on a rotating structure (50), the rotating structure (50) is connected to the third fastening structure (13) by using a third cantilever beam (23), and the rotating structure (50) and the rotating frame (40) are fastened together. The first comb (31) and the second comb (32) are configured to actuate the rotating frame (40) and the rotating structure (50) to rotate around a first axial direction. The third comb (33) and the fourth comb (34) are configured to actuate the rotating platform (60) to rotate around a second axial direction.

## Description

This application claims priority to Chinese Patent Application No. 202111017237.7, filed with the China National Intellectual Property Administration on August 31, 2021 and entitled "ACTUATING MEMBER AND RELATED DEVICE", which is incorporated herein by reference in its entirety.

### TECHNICAL FIELD

This application relates to the MEMS micromirror field, and in particular, to an actuating member and a related device.

### BACKGROUND

A micro-electro-mechanical system (Micro-Electro-Mechanical Systems, MEMS) micromirror is a device used to deflect or modulate a light ray, and has advantages of a small size, low costs, easy integration, high reliability, and the like. At present, the MEMS micromirror is widely used in the fields of optical communication and projection display. Main actuating manners include electrostatic, magnetoelectric, piezoelectric, and thermoelectric manners.

An electrostatic-actuating MEMS micromirror generates an electrostatic force by using an electric potential difference loaded onto an actuating structure of the micromirror, to actuate the MEMS micromirror to perform translation or rotation. The actuating structure of the electrostatic-actuating MEMS micromirror mainly includes a flat electrode structure and an actuating comb structure. For example, actuating combs on two sides of an X axis actuate the micromirror to rotate around the X axis by using a hinge structure. Similarly, electrostatic actuating combs on two sides of a Y axis actuate the micromirror to rotate around the Y axis by using a hinge structure. However, this actuating structure of the MEMS micromirror cannot decouple rotation of the micromirror in the two axial directions, and consequently mutual crosstalk occurs on the rotation of the micromirror in the two axial directions.

### SUMMARY

Embodiments of this application provide an actuating member and an actuating array, so that rotation of a rotating frame and a rotating structure may be decoupled from rotation of a rotating platform, thereby avoiding crosstalk caused by rotation of the actuating member in two axial directions.

According to a first aspect, this application provides an actuating member. The actuating member includes: a substrate, a rotating structure, a rotating frame, a rotating platform, a first fastening structure, a second fastening structure, a third fastening structure, a first cantilever beam, a second cantilever beam, and a third cantilever beam. The first fastening structure, the second fastening structure, and the third fastening structure are fastened to the substrate. The rotating frame is connected to the first fastening structure by using the first cantilever beam, and a first comb is formed on the rotating frame. The first comb is arranged in a staggered manner with a second comb, and the second comb is formed on the second fastening structure. The rotating platform is located at an inner side of the rotating frame, the rotating platform is connected to the rotating frame by using the second cantilever beam, and a third comb is formed on the rotating platform. The third comb is arranged in a staggered manner with a fourth comb, the fourth comb is formed on the rotating structure, the rotating structure is connected to the third fastening structure by using the third cantilever beam, and the rotating structure and the rotating frame are fastened together. The first comb and the second comb are configured to actuate the rotating frame and the rotating structure to rotate around a first axial direction. The third comb and the fourth comb are configured to actuate the rotating platform to rotate around a second axial direction. The first axial direction is perpendicular to the second axial direction.

In this implementation, when the rotating frame is actuated to rotate together with the rotating structure around the first axial direction and the rotating platform is not actuated, a relative position between combs on the rotating platform and combs on the rotating structure remains unchanged, and actuation of the rotating platform to rotate around the second axial direction is not affected. In the foregoing manner, rotation of the rotating frame and the rotating structure may be decoupled from rotation of the rotating platform, thereby avoiding crosstalk caused by rotation of the actuating member in two axial directions.

In a possible implementation, the rotating structure is electrically isolated from the rotating frame, so that different voltages may be loaded onto the third comb and the fourth comb to form an electric potential difference, to facilitate actuating the rotating platform to rotate.

In a possible implementation, each of two sides of the rotating frame is connected to the first fastening structure by using one first cantilever beam, and there is a row of first combs on each of another two sides of the rotating frame. The two rows of first combs are arranged in a staggered manner with two rows of second combs. The two rows of second combs are separately formed on the second fastening structure. Each of two sides of the rotating platform is connected to the rotating frame by using one second cantilever beam, and there is a row of third combs on each of another two sides of the rotating platform. The two rows of third combs are arranged in a staggered manner with two rows of fourth combs. The two rows of fourth combs are respectively formed on two rotating structures, and each of the two rotating structures is connected to the third fastening structure by using one third cantilever beam. In this implementation, the foregoing fastening structures, the cantilever beams, and the combs are generally disposed in pairs and symmetrically placed. This may first improve stability of an overall structure of the actuating member, and ensure that the actuating member may rotate in a forward direction and a reverse direction during rotation around the first axial direction and the second axial direction.

In a possible implementation, when the first comb is parallel to the second comb, one row of first combs is located above one row of second combs, and the other row of first combs is located below the other row of second combs. For this implementation, torque directions of the two groups of combs are the same. This is equivalent to increasing rotation torque. Based on a same electric potential difference, a rotation angle of the rotating frame may be larger.

In a possible implementation, when the third comb is parallel to the fourth comb, one row of third combs is located above one row of fourth combs, and the other row of third combs is located below the other row of fourth combs. For this implementation, torque directions of the two groups of combs are the same. This is equivalent to increasing rotation torque. Based on a same electric potential difference, a rotation angle of the rotating platform may be larger.

In a possible implementation, when the first comb is parallel to the second comb and the third comb is parallel to the fourth comb, the second comb is located below the first comb, and the fourth comb is respectively located below the third comb. This provides a structure in which combs are distributed up and down and arranged in a staggered manner, and improves implementability of this solution.

In a possible implementation, a first fastening platform is fastened to a surface that is of the third fastening structure and that is away from the substrate, and a second fastening platform is fastened to a surface that is of the rotating structure and that is away from the substrate. The first fastening platform is connected to the second fastening platform by using the third cantilever beam, and the third cantilever beam and the first cantilever beam are located on a same plane. The second fastening platform is electrically isolated from the rotating frame, to avoid crosstalk between a voltage on the rotating frame and a voltage on the rotating platform. In this implementation, the first fastening platform and the second fastening platform may be designed to lift the third cantilever beam to a plane the same as that of the first cantilever beam. Because the rotating frame and the rotating structure rotate at the same time, when the third cantilever beam and the first cantilever beam are located on a same plane, a center of gravity may be better controlled when the rotating frame and the rotating structure rotate, and working stability is higher.

In a possible implementation, the third fastening structure is electrically connected to the first fastening platform by using a through-silicon via (through-silicon via, TSV), and the rotating structure is electrically connected to the second fastening platform by using a TSV. This improves practicability of this solution.

In a possible implementation, when the first comb is parallel to the second comb and the third comb is parallel to the fourth comb, the second comb is located above the first comb, and the fourth comb is located above the third comb. This provides another structure in which combs are distributed up and down and arranged in a staggered manner, and improves flexibility of this solution.

In a possible implementation, a third fastening platform is fastened to a surface that is of the rotating structure and that is close to the substrate. The third fastening platform is connected to the third fastening structure by using the third cantilever beam, and the third cantilever beam and the first cantilever beam are located on a same plane. The third fastening platform is electrically isolated from the rotating frame, to avoid crosstalk between a voltage on the rotating frame and a voltage on the rotating platform. In this implementation, the third fastening platform may be designed to lower the third cantilever beam to a plane the same as that of the first cantilever beam. Because the rotating frame and the rotating structure rotate at the same time, when the third cantilever beam and the first cantilever beam are located on a same plane, a center of gravity may be better controlled when the rotating frame and the rotating structure rotate, and working stability is higher.

In a possible implementation, the rotating structure is electrically connected to the third fastening platform by using a TSV. This improves practicability of this solution.

In a possible implementation, the first fastening structure is electrically connected to a first electrode or is grounded, the second fastening structure is electrically connected to a second electrode, and the third fastening structure is electrically connected to a third electrode. There is an electric potential difference between the first comb and the second comb, to actuate the rotating frame and the rotating platform to rotate around the first axial direction at the same time, and there is an electric potential difference between the third comb and the fourth comb, to actuate the rotating platform to rotate around the second axial direction. This enhances implementability of this solution.

In a possible implementation, the second electrode and the third electrode are located on a top surface of the substrate and are electrically isolated from the top surface of the substrate. The second electrode is electrically connected to the second fastening structure through wafer bonding, and the third electrode is electrically connected to the third fastening structure through wafer bonding. This provides a specific implementation of loading a voltage onto each comb, and further enhances implementability of this solution.

In a possible implementation, the second electrode and the third electrode are located on a bottom surface of the substrate, the second electrode is electrically connected to the second fastening structure by using a TSV, and the third electrode is electrically connected to the third fastening structure by using a TSV. In this implementation, because a cavity may be provided on the top surface of the substrate, space is limited. Therefore, an electrode on the bottom surface of the substrate may be connected to an external electrode to facilitate wiring. Alternatively, an electrode on the bottom surface of the substrate may be directly electrically interconnected with a printed circuit board or a package tube housing through soldering. This improves integration of a device.

In a possible implementation, the actuating member further includes a coating structure, and the coating structure covers the rotating frame, the rotating structure, and the rotating platform. The second electrode and the third electrode are located on a surface that is of the coating structure and that is away from the substrate. The second electrode is electrically connected to each second fastening structure by using a TSV, and the third electrode is electrically connected to each third fastening structure by using a TSV. In this implementation, the coating structure may be designed to play a role in dust prevention by preventing dust particles from falling inside the actuating member, to reduce air circulation inside and outside the coating structure, and to increase damping of the overall structure, so that the actuating member may rotate to a required angle more quickly during rotation. In addition, because a cavity may be provided on the top surface of the substrate, space is limited. Therefore, an electrode on the top surface of the coating structure may be electrically interconnected with a printed circuit board or a package tube housing in a wire seating manner, so that a wire leading manner is simpler.

In a possible implementation, the substrate includes a cavity, and the rotating frame, the rotating structure, and the rotating platform are suspended above the cavity. The cavity is provided on the substrate to provide rotation space, and a part of space of the substrate is used, so that an overall structure is more compact.

In a possible implementation, a depth of the cavity is greater than maximum displacement of the rotating frame, the rotating platform, and the rotating structure in a direction perpendicular to the substrate during rotation. In other words, enough rotation space needs to be reserved to avoid a collision with the substrate.

In a possible implementation, the actuating member further includes a stop structure, the stop structure is fastened in the cavity, and a height of the stop structure is less than or equal to the depth of the cavity. The stop structure may play a limiting role, and is configured to prevent a cantilever beam from breaking due to excessive displacement of movable parts connected to the cantilever beam when the actuating member falls off or is affected by an external force.

In a possible implementation, the actuating member further includes a mass balance structure, and the mass balance structure is disposed on a surface that is of the rotating platform and that is close to the substrate. The mass balance structure balances a center of gravity of the overall actuating member, reduces off-axis rotation of the actuating member, and improves stability of the actuating member during rotation.

In a possible implementation, the first cantilever beam is of a straight beam structure, an oblique beam structure, or a folded beam structure, the second cantilever beam is of a straight beam structure, an oblique beam structure, or a folded beam structure, and the third cantilever beam is of a straight beam structure, an oblique beam structure, or a folded beam structure. A machining process of a straight beam is simple, but is susceptible to a residual stress in the machining process. A machining process of a folded beam is complex, but may release a stress, and has greater tolerance to a residual stress in the process.

In a possible implementation, the actuating member further includes a reflective element and a support structure, the support structure is disposed on a surface that is of the rotating platform and that is away from the substrate, and the reflective element is disposed on the support structure. In the foregoing manner, the actuating member configured to actuate the reflective element to rotate is disposed in space under the reflective element, and the actuating member naturally does not occupy space of a plane on which the reflective element is located. In this way, the overall structure may be more compact without sacrificing a size of the reflective element.

In a possible implementation, a reflective film is disposed on a surface of the reflective element to enhance reflection of incident light.

In a possible implementation, the first fastening structure is a fastening frame, and the rotating frame is located at an inner side of the fastening frame. This provides a flexible deformation manner for the actuating member in this application.

In a possible implementation, the first cantilever beam, the second cantilever beam, the third cantilever beam, the first comb, the second comb, the third comb, the fourth comb, the rotating frame, the rotating structure, the rotating platform, the first fastening structure, the second fastening structure, and the third fastening structure are made of any one of monocrystalline silicon, polycrystalline silicon, or amorphous silicon. This further improves practicability of this solution.

According to a second aspect, this application provides an actuating array. The actuating array includes a coating structure and a plurality of actuating members according to any one of the implementations of the first aspect. Each actuating member is coated by the coating structure, and every two adjacent actuating members are separated by the coating structure, to avoid disturbance caused by an air flow to the adjacent actuating members when the actuating member rotates. In addition, the coating structure forms electric field shielding, so that electrical crosstalk between the adjacent actuating members may be reduced.

According to a third aspect, this application provides an actuating control system. The actuating control system includes a printed circuit board, a control chip, a connector, and the actuating member described in the first aspect. The actuating member is packaged by using a tube housing. The control chip, the connector, and the actuating member are fastened to the printed circuit board. The control chip is connected to the actuating member by using the connector. The control chip is configured to output a control signal to the actuating member, to control the actuating member to rotate.

According to a fourth aspect, this application provides an actuating control system. The actuating control system includes a printed circuit board, a control chip, a connector, and the actuating array described in the second aspect. The control chip, the connector, and the actuating array are fastened to the printed circuit board. The control chip is connected to the actuating array by using the connector. The control chip is configured to output a control signal to the actuating array, to control at least one actuating member in the actuating array to rotate.

According to a fifth aspect, this application provides a projection display system. The projection display system includes an encoder, a controller, a light source, a beam shaping apparatus, and the actuating member described in the first aspect. The actuating member includes a reflective element. The encoder is configured to convert a to-be-projected graphic into a control signal, and output the control signal to the controller. The controller is configured to control, based on the control signal, the light source to output at least one light beam. The beam shaping apparatus is configured to perform beam shaping on the at least one light beam, and output at least one shaped light beam to the actuating member. The controller is further configured to control, based on the control signal, the actuating member to rotate, to project the at least one shaped light beam.

According to a sixth aspect, this application provides a projection display system. The projection display system includes an encoder, a controller, a light source, a beam shaping apparatus, and the actuating array described in the second aspect. Each actuating member in the actuating array includes a reflective element. The encoder is configured to convert a to-be-projected graphic into a control signal, and output the control signal to the controller. The controller is configured to control, based on the control signal, the light source to output at least one light beam. The beam shaping apparatus is configured to perform beam shaping on the at least one light beam, and output at least one shaped light beam to the actuating array. The controller is further configured to control, based on the control signal, at least one actuating member in the actuating array to rotate, to project the at least one shaped light beam.

According to a seventh aspect, this application provides a head-up display (Head-up Display, HUD) system. The HUD system includes the projection display system described in the fifth aspect or the sixth aspect. A light beam emitted by the projection display system is reflected by using a wind shield, so that human eyes may see a projected image through the wind shield.

According to an eighth aspect, this application provides a desktop display system. The desktop display system includes the projection display system described in the fifth aspect or the sixth aspect.

According to a ninth aspect, this application provides a smart car light. The car light includes the projection display system described in the fifth aspect or the sixth aspect, and projects an image around a vehicle.

According to a tenth aspect, this application provides a vehicle. The vehicle includes the head-up display system described in the seventh aspect, and/or the smart car light described in the ninth aspect.

According to an eleventh aspect, this application provides an optical cross connect (optical cross connect, OXC) system. The OXC system includes a controller, a first optical fiber array, a second optical fiber array, a first actuating array, and a second actuating array. The first actuating array and the second actuating array are the actuating arrays described in the second aspect, and each of actuating members in the first actuating array and the second actuating array includes a reflective element. The first optical fiber array is configured to couple at least one channel of light to the first actuating array. The controller is configured to control at least one actuating member in the first actuating array to rotate, to reflect the at least one channel of light to the second actuating array. The controller is further configured to control at least one actuating member in the second actuating array to rotate, to couple at least one channel of light to the second optical fiber array.

According to a twelfth aspect, this application provides a spatial light-field regulation-control apparatus. The spatial light-field regulation-control apparatus includes a controller and the actuating array described in the second aspect. Each of actuating members in the actuating array includes a reflective element. The controller is configured to control a plurality of actuating members in the actuating array to rotate, to separately reflect light emitted into the actuating array to different locations in space.

In embodiments of this application, when the rotating frame is actuated to rotate together with the rotating structure around the first axial direction and the rotating platform is not actuated, a relative position between combs on the rotating platform and combs on the rotating structure remains unchanged, and actuation of the rotating platform to rotate around the second axial direction is not affected. In the foregoing manner, rotation of the rotating frame and the rotating structure may be decoupled from rotation of the rotating platform, thereby avoiding crosstalk caused by rotation of the actuating member in two axial directions. In addition, an actuating structure configured to actuate a reflection mirror to rotate is disposed in space under the reflection mirror. Because the actuating structure and the reflection mirror are located on different planes, the actuating structure naturally does not occupy space of a plane on which the reflection mirror is located. In this way, the overall structure of the actuating member may be more compact without sacrificing a size of the reflection mirror.

### BRIEF DESCRIPTION OF DRAWINGS

FIG. 1 is a schematic diagram of a first structure of an actuating member according to an embodiment of this application;
FIG. 2(a) is a schematic diagram of rotation of an actuating member around a first axial direction;
FIG. 2(b) is a schematic diagram of rotation of an actuating member around a second axial direction;
FIG. 2(c) is a schematic diagram of rotation of an actuating member around a first axial direction and a second axial direction at the same time;
FIG. 3 is a schematic plane view of a partial structure of an actuating member according to an embodiment of this application;
FIG. 4(a) is a schematic front view of a second structure of an actuating member according to an embodiment of this application;
FIG. 4(b) is a schematic reverse view of a second structure of an actuating member according to an embodiment of this application;
FIG. 5 is a schematic diagram of a third structure of an actuating member according to an embodiment of this application;
FIG. 6 is a schematic diagram of a fourth structure of an actuating member according to an embodiment of this application;
FIG. 7 is a schematic diagram of a fifth structure of an actuating member according to an embodiment of this application;
FIG. 8 is a schematic diagram of a sixth structure of an actuating member according to an embodiment of this application;
FIG. 9(a) is a schematic diagram of a seventh structure of an actuating member according to an embodiment of this application;
FIG. 9(b) is a schematic diagram of an eighth structure of an actuating member according to an embodiment of this application;
FIG. 10 is a schematic diagram of a ninth structure of an actuating member according to an embodiment of this application;
FIG. 11 is a schematic diagram of a tenth structure of an actuating member according to an embodiment of this application;
FIG. 12 is a first schematic diagram of loading a voltage onto a comb according to an embodiment of this application;
FIG. 13 is a second schematic diagram of loading a voltage onto a comb according to an embodiment of this application;
FIG. 14 is a third schematic diagram of loading a voltage onto a comb according to an embodiment of this application;
FIG. 15 is a schematic diagram of a structure of a substrate according to an embodiment of this application;
FIG. 16 is a schematic diagram of an eleventh structure of an actuating member according to an embodiment of this application;
FIG. 17 is schematic diagrams of several structures of a cantilever beam according to an embodiment of this application;
FIG. 18 is a schematic diagram of a structure of an actuating array according to an embodiment of this application;
FIG. 19 is a schematic diagram of a structure of an MEMS micromirror according to an embodiment of this application;
FIG. 20 is a schematic diagram of a structure of a projection display system according to an embodiment of this application;
FIG. 21 is a schematic diagram of a structure of an OXC system according to an embodiment of this application; and
FIG. 22 is a schematic diagram of a structure of a spatial light-field regulation-control apparatus according to an embodiment of this application.

### DESCRIPTION OF EMBODIMENTS

Embodiments of this application provide an actuating member and a related device, so that rotation of a rotating frame and a rotating structure may be decoupled from rotation of a rotating platform, thereby avoiding crosstalk caused by rotation of the actuating member in two axial directions. In this specification, claims, and accompanying drawings of this application, terms "first", "second", and the like (if any) are intended to distinguish between similar objects but do not necessarily indicate a specific order or sequence. It should be understood that the term used in such a way is interchangeable in proper circumstances, so that embodiments described herein can be implemented in orders other than the order illustrated or described herein. Moreover, terms "include", "contain", and any other variants thereof mean to cover non-exclusive inclusion. For example, a process, method, system, product, or device that includes a list of steps or units is not necessarily limited to those steps or units that are expressly listed, but may include other steps or units not expressly listed or inherent to the process, method, product, or device.

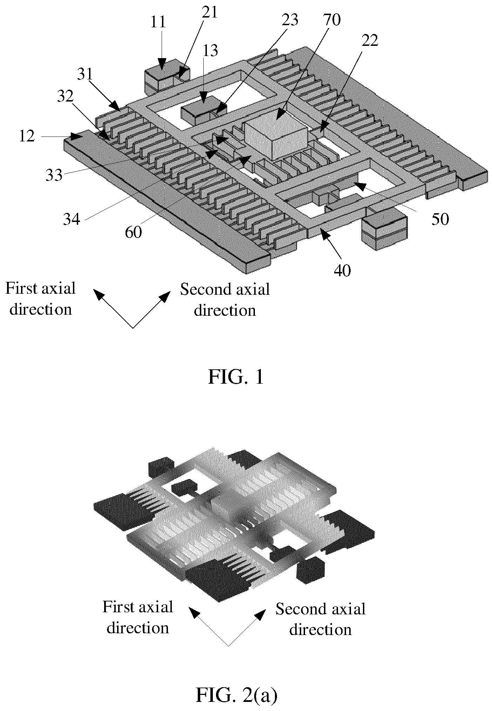

FIG. 1 is a schematic diagram of a first structure of an actuating member according to an embodiment of this application. As shown in FIG. 1, the actuating member includes a first fastening structure 11, a second fastening structure 12, a third fastening structure 13, a first cantilever beam 21, a second cantilever beam 22, a third cantilever beam 23, a first comb 31, a second comb 32, a third comb 33, a fourth comb 34, a rotating frame 40, a rotating structure 50, and a rotating platform 60. The rotating frame 40 is connected to the first fastening structure 11 by using the first cantilever beam 21, and the first comb 31 is formed on the rotating frame 40. The second comb 32 is formed on the second fastening structure 12, and the first comb 31 is arranged in a staggered manner with the second comb 32. The rotating platform 60 is located at an inner side of the rotating frame 40, the rotating platform 60 is connected to the rotating frame 40 by using the second cantilever beam 22, and the third comb is formed on the rotating platform 60. The rotating structure 50 and the rotating frame 40 are fastened together and electrically isolated. The rotating structure 50 is connected to the third fastening structure 13 by using the third cantilever beam 23. The fourth comb 34 is formed on the rotating structure 50, and the third comb 33 is arranged in a staggered manner with the fourth comb 34. The first fastening structure 11, the second fastening structure 12, and the third fastening structure 13 each are fastened to a substrate. A diagram including a structure of the substrate is provided in a subsequent embodiment. A support structure 70 is further disposed on the rotating platform 60, and the support structure 70 is configured to fasten a reflection mirror. A diagram including a structure of the reflection mirror is provided in a subsequent embodiment. It should be noted that components of the actuating member shown in FIG. 1 may be made of a highly doped silicon material, for example, monocrystalline silicon, polycrystalline silicon, or amorphous silicon. In addition, the components of the actuating member may be made of a same material or different materials.

The first comb 31 and the second comb 32 generate electrostatic forces by loading different voltages, thereby actuating the rotating frame 40 to rotate around a first axial direction. In addition, because the rotating frame 40 and the rotating structure 50 are fastened together, the rotating platform 60 is connected to the rotating frame 40 by using the second cantilever beam 22. Therefore, the rotating structure 50 and the rotating platform 60 also rotate together with the rotating frame 40 around the first axial direction. The third comb 33 and the fourth comb 34 generate electrostatic forces by loading different voltages, thereby actuating the rotating platform 60 to rotate around a second axial direction. The first axial direction is perpendicular to the second axial direction. It should be understood that the first cantilever beam 21 and the third cantilever beam 23 are independent of each other and do not need to be fastened together with one above the other. In addition, both the first cantilever beam 21 and the third cantilever beam 23 are disposed along the first axial direction or in a direction parallel to the first axial direction, so that the rotating frame 40 and the rotating structure 50 may rotate together around the first axial direction. The second cantilever beam 22 is disposed along the second axial direction or in a direction parallel to the second axial direction, so that the rotating platform 60 may rotate around the second axial direction.

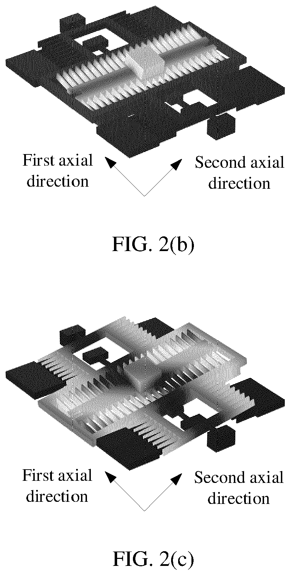

FIG. 2(a) to FIG. 2(c) show schematic diagrams of rotation of the actuating member around different axial directions. FIG. 2(a) is a schematic diagram of rotation of the actuating member around the first axial direction. FIG. 2(b) is a schematic diagram of rotation of the actuating member around the second axial direction. FIG. 2(c) is a schematic diagram of rotation of the actuating member around the first axial direction and the second axial direction at the same time.

In the foregoing design manner, when the rotating frame 40 is actuated to rotate together with the rotating structure 50 around the first axial direction and the rotating platform 60 is not actuated, a relative position between the third comb 33 on the rotating platform 60 and the fourth comb 34 on the rotating structure 50 remains unchanged, and actuation of the rotating platform 60 to rotate around the second axial direction is not affected. In this way, rotation of the rotating frame 40 and the rotating structure 50 is decoupled from rotation of the rotating platform 60, thereby avoiding crosstalk caused by rotation of the actuating member in two axial directions.

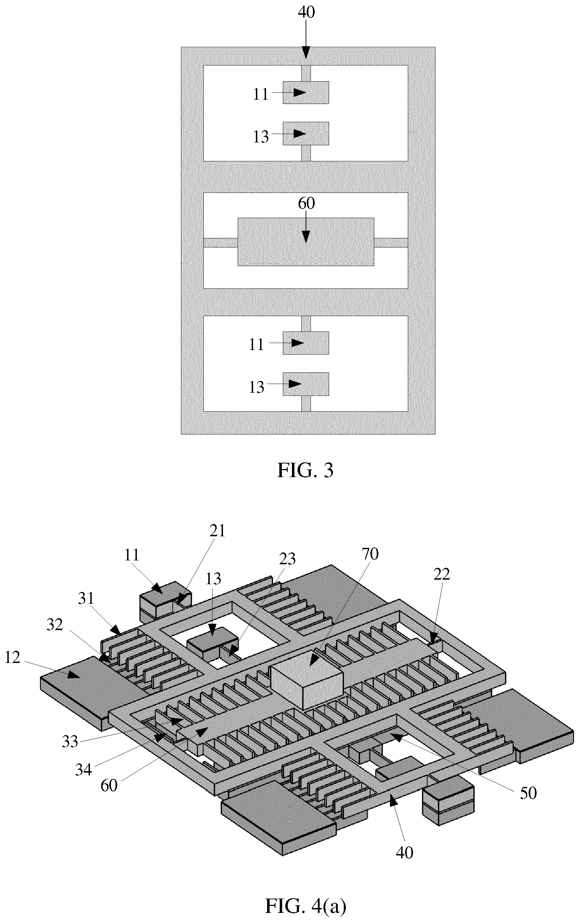

In a possible implementation, the foregoing fastening structures, the cantilever beams, and the combs are generally disposed in pairs and symmetrically placed. As shown in FIG. 1, each of two sides of the rotating frame 40 is connected to the first fastening structure 11 by using one first cantilever beam 21, and a row of first combs 31 is formed on each of another two sides of the rotating frame 40. A row of second combs 32 is formed on each of two second fastening structures 12, and the two rows of first combs 31 are respectively arranged in a staggered manner with the two rows of second combs 32. Each of two sides of the rotating platform 60 is connected to the rotating frame 40 by using one second cantilever beam 22, and a row of third combs 33 is formed on each of another two sides of the rotating platform 60. Two rows of fourth combs 34 are respectively formed on two rotating structures 50, each of the two rotating structures 50 is separately connected to the third fastening structure 13 by using one third cantilever beam 23, and the two rows of third combs 33 are respectively arranged in a staggered manner with the two rows of fourth combs 34. In another possible implementation, FIG. 3 is a schematic plane view of a partial structure of the actuating member according to this embodiment of this application. As shown in FIG. 3, the first fastening structure 11 may alternatively be disposed on an inner side of the rotating frame 40.

It should be noted that, one group of first combs 31 and second combs 32 are configured to actuate the rotating frame 40 and the rotating structure 50 to rotate clockwise around the first axial direction, and the other group of first combs 31 and second combs 32 are configured to actuate the rotating frame 40 and the rotating structure 50 to rotate counterclockwise around the first axial direction. Similarly, one group of third combs 33 and fourth combs 34 are configured to actuate the rotating platform 60 to rotate clockwise around the second axial direction, and the other group of third combs 33 and fourth combs 34 are configured to actuate the rotating platform 60 to rotate counterclockwise around the second axial direction. In the foregoing symmetric design manner, stability of an overall structure of the actuating member may be improved. Certainly, during actual application, the foregoing symmetric design manner may not be used. For example, in some scenarios, it is only required that the actuating member rotates unidirectionally during rotation around the first axial direction and the second axial direction, so that an area of an actuating structure may be reduced to cut costs.

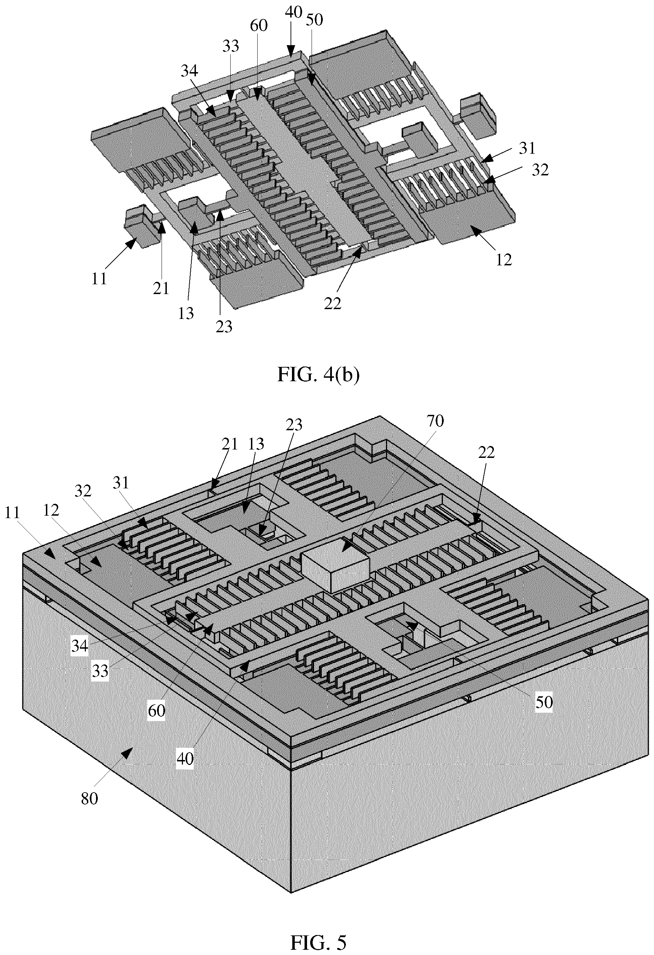

FIG. 4(a) is a schematic front view of a second structure of the actuating member according to this embodiment of this application. FIG. 4 (b) is a schematic reverse view of the second structure of the actuating member according to this embodiment of this application. A difference from the structure shown in FIG. 1 lies in that the actuating structure shown in FIG. 4(a) and FIG. 4(b) includes four second fastening structures 12. This is equivalent to splitting two second fastening structures 12 into four on the basis of the structure shown in FIG. 1. The rotating frame 40 adopts a "cross"-shaped structure shown in FIG. 4(a), and the four second fastening structures 12 are respectively located at positions of four corners on an outer side of the rotating frame 40. Correspondingly, the actuating structure shown in FIG. 4(a) and FIG. 4(b) include four rows of first combs 31 and four rows of second combs 32, and the four rows of first combs 31 are respectively arranged in a staggered manner with the four rows of second combs 32. It should be understood that, the structure shown in FIG. 4(a) and FIG. 4(b) is merely a variation based on the structure shown in FIG. 1. During actual application, a quantity of second fastening structures may further be expanded to 6, 8, or the like. This is not specifically limited herein. In addition, quantities of the first fastening structures 11 and the third fastening structures 13 are not limited in this application. For example, a plurality of first fastening structures 11 may be disposed side by side on a same side of the rotating frame 40, and each first fastening structure 11 is connected to the rotating frame 40 by using one first cantilever beam 21, to enhance overall stability of the actuating member. Similarly, a plurality of third fastening structures 13 may be disposed side by side on a same side of each rotating structure 50, and each third fastening structure 13 is connected to the rotating structure 50 by using one third cantilever beam 23. Similarly, a same side of the rotating platform 60 may also be connected to the rotating frame 40 by using a plurality of second cantilever beams 22 disposed side by side.

FIG. 5 is a schematic diagram of a third structure of the actuating member according to this embodiment of this application. As shown in FIG. 5, the first fastening structure 11, the second fastening structure 12, and the third fastening structure 13 each are fastened to the substrate 80. A difference from the foregoing actuating member lies in that the first fastening structure 11 in the structure shown in FIG. 5 is a fastening frame, and the rotating frame 40 is located at an inner side of the fastening frame. This provides a flexible deformation manner for the actuating member in this application.

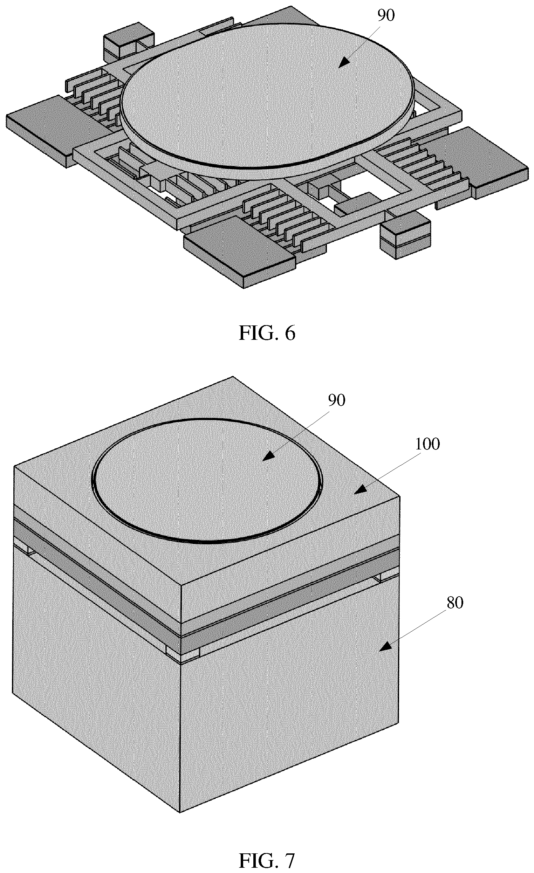

FIG. 6 is a schematic diagram of a fourth structure of the actuating member according to this embodiment of this application. As shown in FIG. 6, on the basis of the structure shown in FIG. 4(a), a reflective element 90 is placed on the support structure 70, and a reflective film may be further disposed on a surface of the reflective element 90, to enhance reflection of incident light. The reflective film may be specifically a metal film, a multilayer dielectric film, or the like. The reflective element 90 may be in a plurality of shapes, for example, a circle, an ellipse, or a rectangle. This is not specifically limited herein. A material of the reflective element 90 may be any one of monocrystalline silicon, polycrystalline silicon, or amorphous silicon. It should be understood that the structure shown in FIG. 6 may be considered as an MEMS micromirror, and rotation of the rotating frame 40 or the rotating platform 60 also drives the reflective element 90 to rotate at the same time, so that incident light is reflected to different directions by using the reflective element 90. It should be noted that, in this application, the actuating member configured to actuate the reflective element to rotate is disposed in space under the reflective element, and the actuating member naturally does not occupy space of a plane in which the reflective element is located. In this way, the overall structure may be more compact without sacrificing a size of the reflective element.

FIG. 7 is a schematic diagram of a fifth structure of the actuating member according to this embodiment of this application. As shown in FIG. 7, the actuating member further includes a coating structure 100. The coating structure 100 covers the rotating frame 40, the rotating structure 50, and the rotating platform 60. Specifically, the coating structure 100 may be filled around the support structure 70, so that the reflective element 90 is wrapped by the coating structure 100. It should be understood that the coating structure 100 does not wrap a reflective surface of the reflective element 90. In addition, a gap is reserved between the reflective element 90 and the coating structure 100, so that the reflective element 90 may rotate normally. A material of the coating structure 100 may be any one of monocrystalline silicon, polycrystalline silicon, or amorphous silicon. It should be noted that the coating structure 100 may be designed to play a role in dust prevention by preventing dust particles from falling inside the actuating member, to reduce air circulation inside and outside the coating structure, and to increase damping of the overall structure, so that the actuating member may rotate to a required angle more quickly during rotation.

It should be noted that, in the actuating member provided in this application, the rotating frame 40 and the rotating structure 50 are fastened together in a direction perpendicular to the substrate 80. To be specific, the rotating frame 40 and the rotating structure 50 are in a position relationship in which one is above the other. The rotating frame 40 and the rotating structure 50 may be fastened together and electrically isolated by disposing a layer of electrical insulation material. The electrical insulation material may be a dielectric material, for example, silicon oxide, silicon nitride, aluminum oxide, or aluminum nitride. Correspondingly, the first comb 31 and the second comb 32 are in a position relationship in which one is above the other, and the third comb 33 and the fourth comb 34 are also in a position relationship in which one is above the other. During actual application, there may be a plurality of variations, as separately described below. It should be understood that the upper-lower position relationship between combs is viewed when upper and lower combs are in a parallel state.

As shown in FIG. 4(a), the second comb 32 is located below the first comb 31, the fourth comb 34 is located below the third comb 33, and the rotating structure 50 is located below the rotating frame 40.

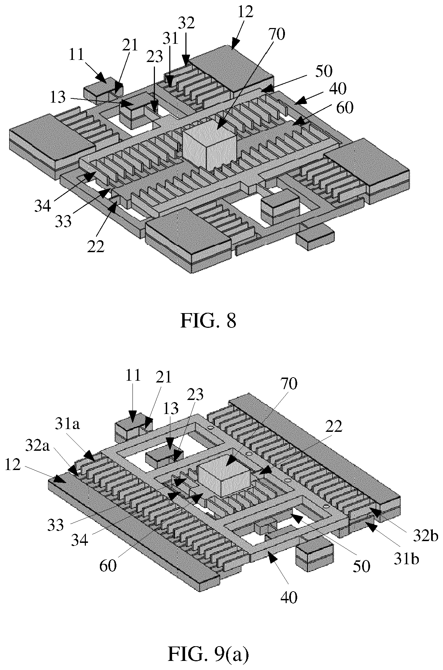

FIG. 8 is a schematic diagram of a sixth structure of the actuating member according to this embodiment of this application. As shown in FIG. 8, the second comb 32 is located above the first comb 31, the fourth comb 34 is located above the third comb 33, and the rotating structure 50 is located above the rotating frame 40.

FIG. 9(a) is a schematic diagram of a seventh structure of the actuating member according to this embodiment of this application. As shown in FIG. 9(a), one row of first combs 31a is located above one row of second combs 32a, and the other row of first combs 31b is located below the other row of second combs 32b. For this implementation, torque directions of the two groups of combs are the same. This is equivalent to increasing rotation torque. Based on a same electric potential difference, a rotation angle of the rotating frame may be larger. For example, there is an electric potential difference between the first comb 31a and the second comb 32a, and the second comb 32a attracts the first comb 31a to rotate in a direction close to the second comb 32a, that is, in a clockwise rotation direction. Similarly, because the first comb 31b is electrically connected to the rotating frame 40 in a through-silicon via (through-silicon via, TSV) manner, the first comb 31b and the first comb 31a load a same voltage. In addition, the second comb 32b and the second comb 32a load a same voltage, and the second comb 32b attracts the first comb 31b to rotate in a direction close to the second comb 32b, thereby increasing rotation torque. Certainly, by using a similar design manner, the rotating frame 40 may also rotate counterclockwise around the first axial direction and increase rotation torque. Details are not described herein.

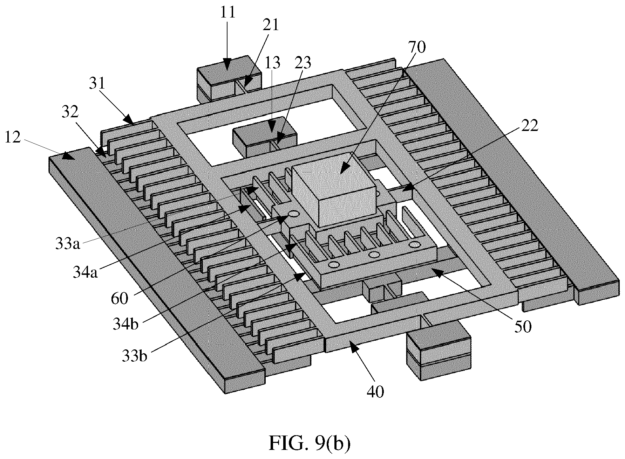

FIG. 9(b) is a schematic diagram of an eighth structure of the actuating member according to this embodiment of this application. As shown in FIG. 9(b), for the third comb 33 and the fourth comb 44, a design manner similar to that shown in FIG. 9(a) may also be used. To be specific, one row of third combs 33a is located above one row of fourth combs 34a, and the other row of third combs 33b is located below the other row of fourth combs 34b. Similarly, torque directions of the two groups of combs are the same. This is equivalent to increasing rotation torque. Based on a same electric potential difference, a rotation angle of the rotating platform may be larger. For example, there is an electric potential difference between the third comb 33a and the fourth comb 34a, and the fourth comb 34a attracts the third comb 33a to rotate in a direction close to the fourth comb 34a, that is, in a clockwise rotation direction. Similarly, because the third comb 33b is electrically connected to the rotating platform 60 in a TSV manner, the third comb 33b and the third comb 33a load a same voltage. In addition, the fourth comb 34b and the fourth comb 34a load a same voltage, and the fourth comb 34b attracts the third comb 33b to rotate in a direction close to the fourth comb 34b, thereby increasing rotation torque. Certainly, by using a similar design manner, the rotating platform 60 may also rotate counterclockwise around the first axial direction and increase rotation torque. Details are not described herein.

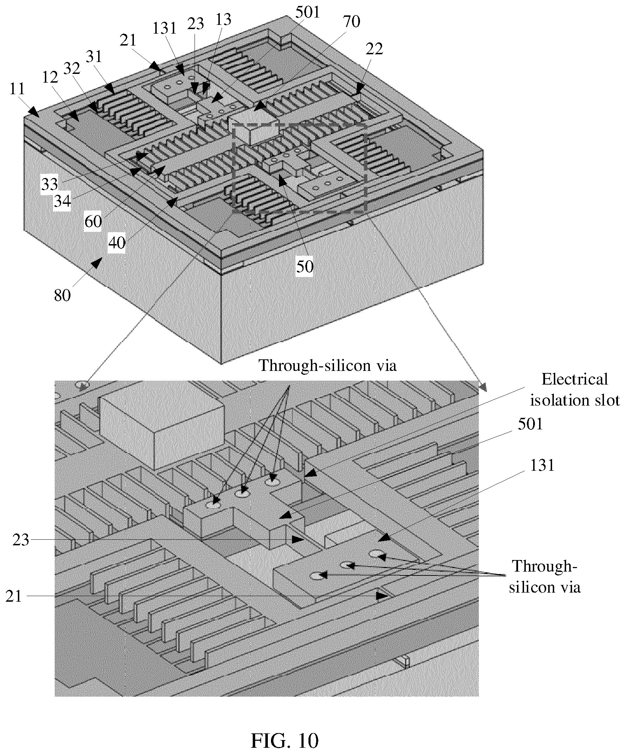

FIG. 10 is a schematic diagram of a ninth structure of the actuating member according to this embodiment of this application. As shown in FIG. 10, as a deformation of the structure shown in FIG. 5, a first fastening platform 131 is fastened to a surface that is of the third fastening structure 13 and that is away from the substrate 80. A second fastening platform 501 is fastened to a surface that is of the rotating structure 50 and that is away from the substrate 80. The first fastening platform 131 is connected to the second fastening platform 501 by using the third cantilever beam 23. The third fastening structure 13 is electrically connected to the first fastening platform 131 in a TSV manner, and the rotating structure 50 is also electrically connected to the second fastening platform 501 in a TSV manner, so that a voltage on the rotating structure 50 is consistent with a voltage loaded onto the third fastening structure 13. The TSV may be highly doped silicon, copper, tungsten, or another suitable material, and a cross section shape of the TSV may be a circle, a rectangle, an ellipse, or the like. Correspondingly, an electrical isolation slot is provided between the second fastening platform 501 and the rotating frame 40, to avoid crosstalk between a voltage on the rotating frame 40 and the voltage on the rotating platform 50. It should be understood that, the first fastening platform 131 and the second fastening platform 501 may be designed to lift the third cantilever beam 23 to a plane the same as that of the first cantilever beam 21. Because the rotating frame 40 and the rotating structure 50 rotate at the same time, when the third cantilever beam 23 and the first cantilever beam 21 are located on a same plane, a center of gravity may be better controlled when the rotating frame 40 and the rotating structure 50 rotate, and working stability is higher.

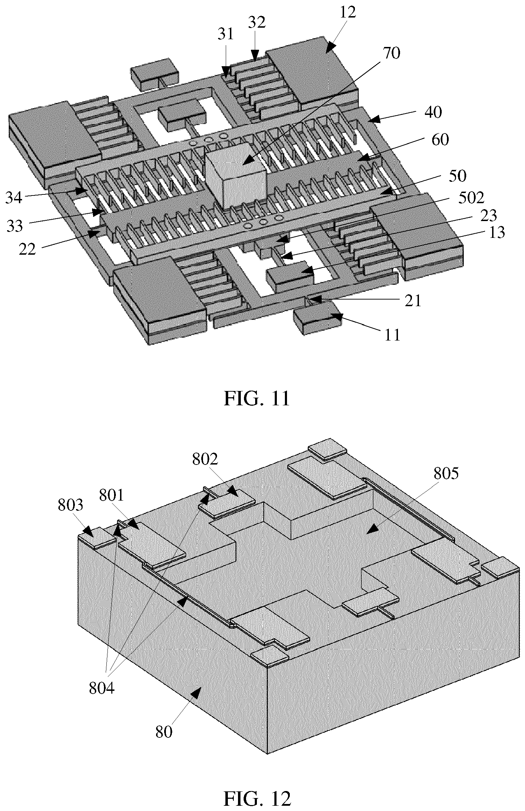

FIG. 11 is a schematic diagram of a tenth structure of the actuating member according to this embodiment of this application. As shown in FIG. 11, as a deformation of the structure shown in FIG. 8, a third fastening platform 502 is fastened to a surface that is of the rotating structure 50 and that is close to the substrate 80. The third fastening platform 502 is connected to the third fastening structure 13 by using the third cantilever beam 23. The rotating structure 50 may be electrically connected to the third fastening platform 502 in a TSV manner, so that the voltage on the rotating structure 50 is consistent with the voltage loaded onto the third fastening structure 13. Correspondingly, an electrical isolation slot is provided between the third fastening platform 502 and the rotating frame 40, to avoid crosstalk between the voltage on the rotating frame 40 and the voltage on the rotating platform 50. It should be understood that, the third fastening platform 502 may be designed to lower the third cantilever beam 23 to a plane the same as that of the first cantilever beam 21. Because the rotating frame 40 and the rotating structure 50 rotate at the same time, when the third cantilever beam 23 and the first cantilever beam 21 are located in a same plane, a center of gravity may be better controlled when the rotating frame 40 and the rotating structure 50 rotate, and working stability is higher.

The following describes several manners of loading a voltage onto each comb in the actuating member.

FIG. 12 is a first schematic diagram of loading a voltage onto the comb according to this embodiment of this application. As shown in FIG. 12, on the basis of the structure shown in FIG. 5, only the substrate and an electrode are reserved for illustration. A cavity 805 may be further provided on the substrate 80. The rotating frame 40, the rotating structure 50, and the rotating platform 60 each are suspended above the cavity 805. A depth of the cavity 805 is greater than maximum displacement of the rotating frame 40, the rotating structure 50, and the rotating platform 60 in a direction perpendicular to the substrate 80 during rotation. In other words, enough rotation space needs to be reserved to avoid a collision with the substrate 80. In addition, the cavity 805 is provided on the substrate 80 to provide rotation space, and a part of space of the substrate 80 is used, so that an overall structure is more compact. Certainly, during actual application, the foregoing fastening structures may alternatively be lifted on the substrate 80, to obtain enough space to support rotation of the rotating frame 40, the rotating structure 50, and the rotating platform 60.

An electrode 801, an electrode 802, a bonding point 803, and a wire 804 each are disposed on a same layer on the substrate 80. The layer may be referred to as a bonding wire layer in this application. An insulation layer is further disposed between the bonding wire layer and the substrate 80. Specifically, the electrode 801 is electrically connected to the second fastening structure 12 in a wafer bonding manner. The electrode 802 is electrically connected to the third fastening structure 13 in a wafer bonding manner. It should be understood that the first fastening structure 11 may be connected to the electrode in a similar manner, or may be grounded. The manner of connecting the first fastening structure 11 to the electrode is not shown in FIG. 12. The electrode 801 and the electrode 802 may be separately connected to an external electrode by using a wire, and electrodes 801 at different locations on a same side of the substrate may also be connected by using a wire.

In the foregoing manner, a voltage loaded onto the second fastening structure 12 and the second comb 32 is Vx. A voltage loaded onto the third fastening structure 13, the third cantilever beam 23, the rotating structure, and the fourth comb is Vy. A voltage loaded onto the first fastening structure 11, the first cantilever beam 21, the rotating frame 40, the first comb 31, the second cantilever beam 22, the rotating platform 60, and the third comb 33 is Vr. An electric potential difference between the first comb 31 and the second comb 32 is |Vr-Vx|, and an electric potential difference between the third comb 33 and the fourth comb 34 is |Vr-Vy|. It should be noted that the voltage loaded onto the first comb 31 and the third comb 33 may be constant. A voltage is loaded onto a corresponding second comb 32 based on an actual requirement, so that the rotating frame 40 rotates clockwise or counterclockwise around the first axial direction. The structure shown in FIG. 1 is used as an example. A voltage may be loaded onto one row of second combs 32, and no voltage is loaded onto the other row of second combs 32. Similarly, a voltage may also be loaded onto a corresponding fourth comb 34 based on an actual requirement, so that the rotating platform 60 rotates clockwise or counterclockwise around the second axial direction.

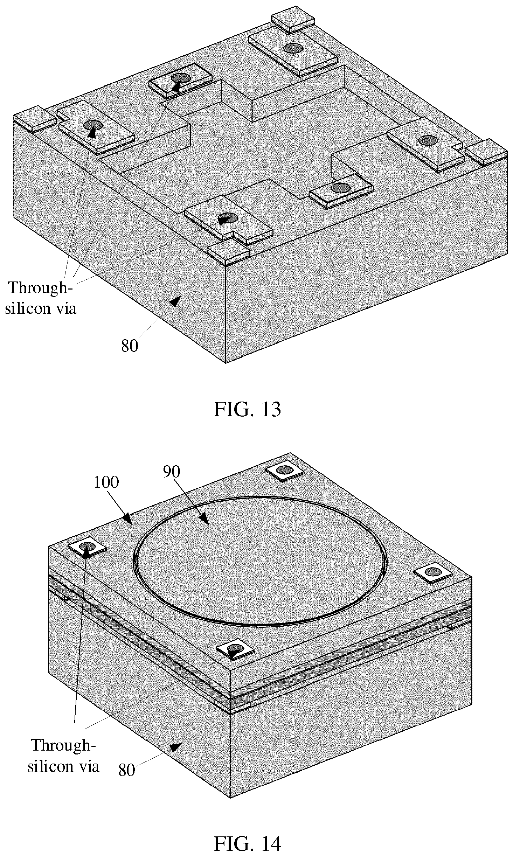

FIG. 13 is a second schematic diagram of loading a voltage onto the comb according to this embodiment of this application. As shown in FIG. 13, a difference from the structure shown in FIG. 12 lies in that an electrode is also disposed on a bottom surface of the substrate 80, and the electrode located on the bottom surface of the substrate 80 is electrically connected to the electrode located on a top surface of the substrate 80 in a TSV manner. The electrode on the bottom surface of the substrate 80 may be a conductive pad, a metal solder bump (solder bump), or the like. Because a cavity may be provided on the top surface of the substrate, space is limited. Therefore, the electrode on the bottom surface of the substrate 80 may be connected to an external electrode to facilitate wiring. Alternatively, the electrode on the bottom surface of the substrate 80 may be directly electrically interconnected with a printed circuit board or a package tube housing through soldering. This improves integration of a device.

FIG. 14 is a third schematic diagram of loading a voltage onto the comb according to this embodiment of this application. As shown in FIG. 14, a difference from the structure shown in FIG. 12 lies in that an electrode is also disposed on a top surface of the coating structure 100. The electrode on the top surface of the coating structure 100 is electrically connected to the electrode on the top surface of the substrate 80 in a TSV manner. Because a cavity may be provided on the top surface of the substrate, space is limited. Therefore, the electrode on the top surface of the coating structure 100 may be electrically interconnected with a printed circuit board or a package tube housing in a wire seating manner, so that a wire leading manner is simpler.

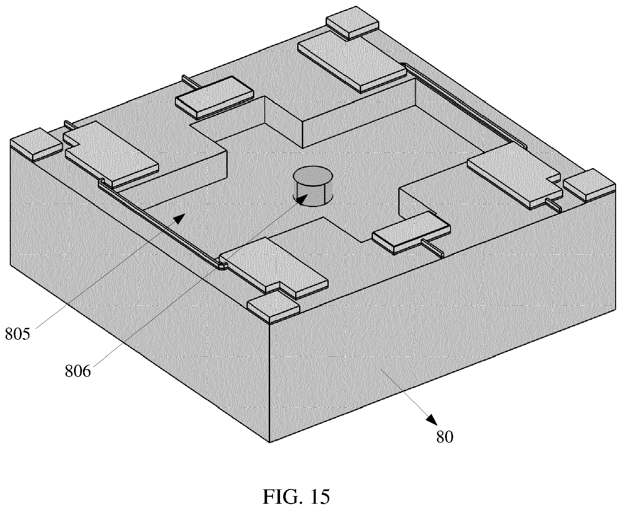

FIG. 15 is a schematic diagram of a structure of the substrate according to this embodiment of this application. As shown in FIG. 15, in a possible implementation, a stop structure 806 is further fastened in the cavity 805. A height of the stop structure 806 is less than or equal to the depth of the cavity 805. A cross section of the stop structure 806 may be in a shape of a circle, an ellipse, a rectangle, a triangle, or the like. The stop structure 806 may play a limiting role, and is configured to prevent a cantilever beam from breaking due to excessive displacement of the rotating frame 40, the rotating structure 50, and the rotating platform 60 that are connected to the cantilever beam when the actuating member falls off or is impacted by an external force. A material of the stop structure 806 may be any one of monocrystalline silicon, polycrystalline silicon, or amorphous silicon. It should be understood that the stop structure 806 is preferably fastened at a center of the bottom of the cavity 805 or at a position close to the center of the bottom of the cavity 805, to avoid affecting rotation of the rotating frame 40, the rotating structure 50, and the rotating platform 60.

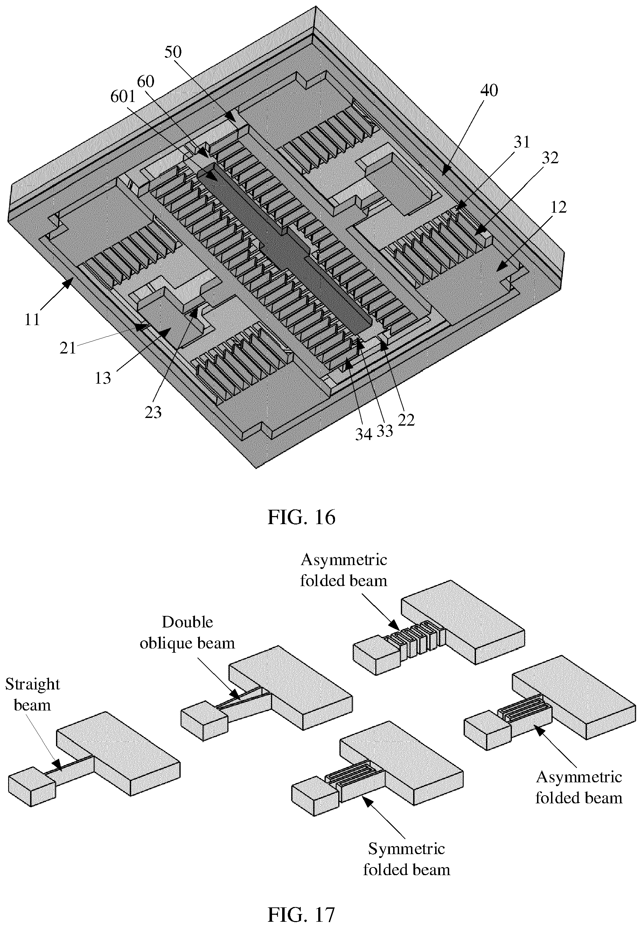

FIG. 16 is a schematic diagram of an eleventh structure of the actuating member according to this embodiment of this application. As shown in FIG. 16, a mass balance structure 601 is further fastened to a surface that is of the rotating platform 60 and that is close to the substrate 80. The mass balance structure 601 rotates together with the rotating platform 60. The mass balance structure may be a structure of a cuboid, a cylinder, or the like. A material of the mass balance structure 60 may be any one of monocrystalline silicon, polycrystalline silicon, or amorphous silicon. The mass balance structure 60 balances a center of gravity of the overall actuating member, reduces off-axis rotation of the actuating member, and improves stability of the actuating member during rotation.

FIG. 17 is schematic diagrams of several structures of the cantilever beam according to this embodiment of this application. As shown in FIG. 17, each of the cantilever beams in the actuating member may be designed in a plurality of different manners. For example, the cantilever beams may be of a straight beam structure, a double oblique beam structure, a symmetric folded beam structure, or an asymmetric folded beam structure. This is not specifically limited herein. A machining process of a straight beam is simple, but is susceptible to a residual stress in the machining process. A machining process of a folded beam is complex, but may release a stress, and has greater tolerance to a residual stress in the process.

The foregoing describes the actuating member provided in this application. Based on this, a plurality of actuating members may be combined to form an actuating array as described below.

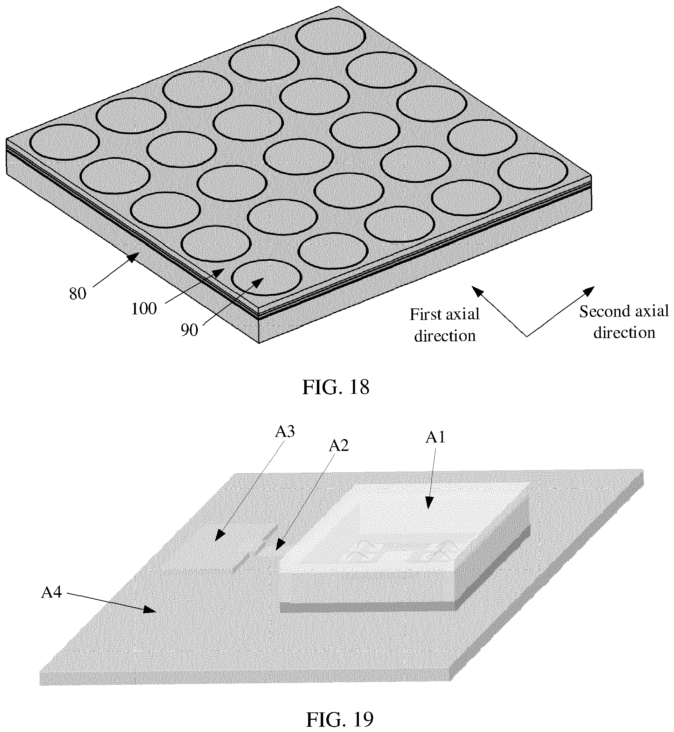

FIG. 18 is a schematic diagram of a structure of the actuating array according to an embodiment of this application. As shown in FIG. 18, the plurality of actuating members are arranged in a first axial direction and a second axial direction to form the actuating array. The plurality of actuating members may share a same substrate 80. In addition, each actuating member is coated by a coating structure 100, and every two adjacent actuating members are separated by the coating structure 100, to avoid disturbance caused by an air flow to the adjacent actuating members when the actuating member rotates. In addition, the coating structure 100 forms electric field shielding, so that electrical crosstalk between the adjacent actuating members may be reduced. It should be understood that each actuating member is independently controlled, and a reflective element 90 of the actuating member may be rotated to a proper position based on an actual requirement.

It should be understood that the foregoing actuating member and the actuating array may be applied to an optical communication field, for example, an optical cross connect (optical cross connect, OXC), a variable optical attenuator (Variable Optical Attenuator, VOA), wavelength selective switching (wavelength selective switching, WSS), or the like, or may be applied to an optical display module required in a field of light detection and ranging (light detection and ranging, LiDAR), a head-up display (Head-up Display, HUD), augmented reality (Augmented Reality, AR), or the like. The following describes several specific application scenarios.

FIG. 19 is a schematic diagram of a structure of an actuating control system according to an embodiment of this application. As shown in FIG. 19, the actuating control system includes an actuating member A1, a connector A2, a control chip A3, and a printed circuit board A4. The actuating member A1, the connector A2, and the control chip A3 are fastened to the printed circuit board A4. The control chip A3 is connected to the actuating member A1 by using the connector A2. The actuating member A1 is specifically the actuating member described in the foregoing embodiment, and the actuating member may be packaged by using a package tube housing with a transparent top part. Specifically, the control chip A3 is configured to output a control signal to the actuating member A1, to control the actuating member A1 to rotate. It should be noted that the actuating control system shown in FIG. 19 may also use the actuating array shown in FIG. 18 to replace the actuating member. A working manner is similar to that described in this embodiment. Details are not described herein.

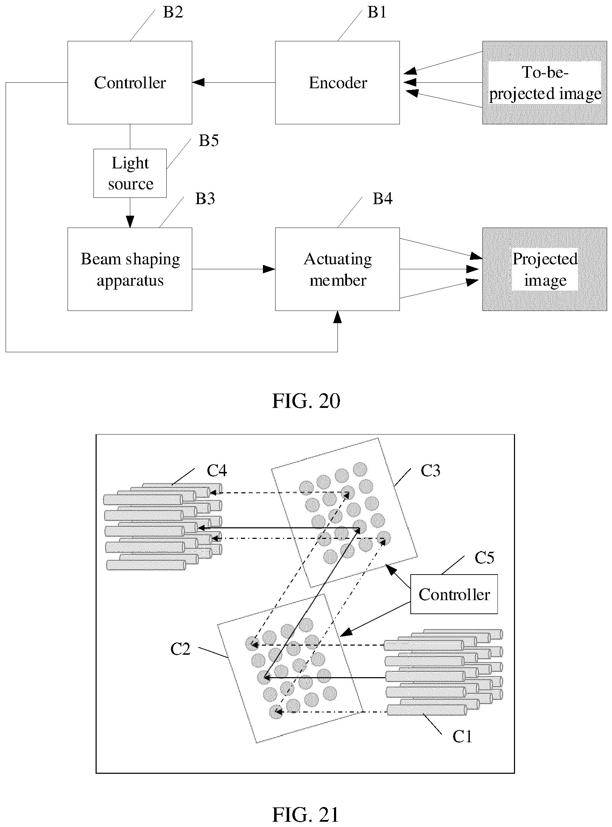

FIG. 20 is a schematic diagram of a structure of a projection display system according to an embodiment of this application. As shown in FIG. 20, the projection display system includes an encoder B 1, a controller B2, a beam shaping apparatus B3, an actuating member B4, and a light source B5. The actuating member B4 is the actuating member described in the foregoing embodiment, and the actuating member includes a reflective element. Specifically, the encoder B 1 is configured to convert a to-be-projected graphic into a control signal, and output the control signal to the controller B2. The controller B2 controls, based on the control signal, the light source B5 to output at least one light beam. The beam shaping apparatus B3 performs beam shaping on the at least one light beam, and outputs at least one shaped light beam to the actuating member B4. The controller B2 further controls, based on the control signal, the actuating member B4 to rotate, to project the at least one shaped light beam, thereby forming a projected image. It should be noted that, the projection display system shown in FIG. 20 may also use the actuating array shown in FIG. 18 to replace the actuating member. A working manner is similar to that described in this embodiment. Details are not described herein.

FIG. 21 is a schematic diagram of a structure of an OXC system according to an embodiment of this application. As shown in FIG. 21, the OXC system includes a first optical fiber array C1, a first actuating array C2, a second actuating array C3, a second optical fiber array C4, and a controller C5. The first actuating array C2 and the second actuating array C3 may be the actuating arrays described in FIG. 18, and each of actuating members in the first actuating array C2 and the second actuating array C3 includes a reflective element. Specifically, the first optical fiber array C1 is configured to couple at least one channel of light to at least one actuating member in the first actuating array C2. The controller C5 controls the at least one actuating member in the first actuating array C2 to rotate, to reflect the at least one channel of light to at least one actuating member in the second actuating array C3. The controller C5 then controls the at least one actuating member in the second actuating array C3 to rotate, to couple the at least one channel of light to the second optical fiber array C4. In this manner, light that carries a service can be switched between different ports.

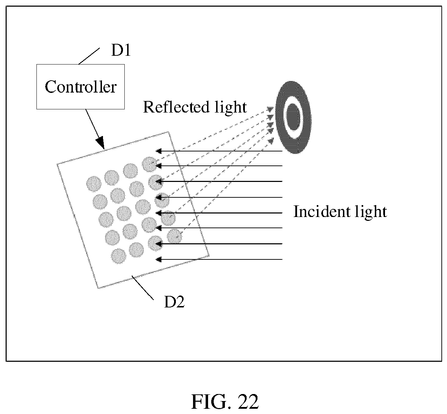

FIG. 22 is a schematic diagram of a structure of a spatial light-field regulation-control apparatus according to an embodiment of this application. As shown in FIG. 22, the spatial light-field regulation-control apparatus includes a controller D1 and an actuating array D2. The actuating array D2 may be the actuating array described in FIG. 18, and each of actuating members in the actuating array includes a reflective element. Specifically, the controller D1 controls a plurality of actuating members in the actuating array D2 to rotate to different angles, to reflect incident light to different locations in space, thereby implementing intensity and phase distribution of reflected light in the space.

It should be noted that the foregoing embodiments are merely used to describe technical solutions of this application, but are not intended to limit this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. An actuating member, comprising: a substrate, a rotating structure, a rotating frame, a rotating platform, a first fastening structure, a second fastening structure, a third fastening structure, a first cantilever beam, a second cantilever beam, and a third cantilever beam, wherein the first fastening structure, the second fastening structure, and the third fastening structure are fastened to the substrate;
the rotating frame is connected to the first fastening structure by using the first cantilever beam, a first comb is formed on the rotating frame, the first comb is arranged in a staggered manner with a second comb, the second comb is formed on the second fastening structure, the rotating platform is located at an inner side of the rotating frame, the rotating platform is connected to the rotating frame by using the second cantilever beam, a third comb is formed on the rotating platform, the third comb is arranged in a staggered manner with a fourth comb, the fourth comb is formed on the rotating structure, the rotating structure is connected to the third fastening structure by using the third cantilever beam, and the rotating structure and the rotating frame are fastened together; and
the first comb and the second comb are configured to actuate the rotating frame and the rotating structure to rotate around a first axial direction, the third comb and the fourth comb are configured to actuate the rotating platform to rotate around a second axial direction, and the first axial direction is perpendicular to the second axial direction.

2. The actuating member according to claim 1, wherein the rotating structure is electrically isolated from the rotating frame.

3. The actuating member according to claim 1 or 2, wherein each of two sides of the rotating frame is connected to the first fastening structure by using one first cantilever beam, there is a row of first combs on each of another two sides of the rotating frame, the two rows of first combs are arranged in a staggered manner with two rows of second combs, the two rows of second combs are separately formed on the second fastening structure, each of two sides of the rotating platform is connected to the rotating frame by using one second cantilever beam, there is a row of third combs on each of another two sides of the rotating platform, the two rows of third combs are arranged in a staggered manner with two rows of fourth combs, the two rows of fourth combs are respectively formed on two rotating structures, and each of the two rotating structures is connected to the third fastening structure by using one third cantilever beam.

4. The actuating member according to claim 3, wherein when the first comb is parallel to the second comb, one row of first combs is located above one row of second combs, and the other row of first combs is located below the other row of second combs.

5. The actuating member according to claim 3 or 4, wherein when the third comb is parallel to the fourth comb, one row of third combs is located above one row of fourth combs, and the other row of third combs is located below the other row of fourth combs.

6. The actuating member according to any one of claims 1 to 3, wherein when the first comb is parallel to the second comb and the third comb is parallel to the fourth comb, the second comb is located below the first comb, and the fourth comb is respectively located below the third comb.

7. The actuating member according to claim 6, wherein a first fastening platform is fastened to a surface that is of the third fastening structure and that is away from the substrate, a second fastening platform is fastened to a surface that is of the rotating structure and that is far away from the substrate, the first fastening platform is connected to the second fastening platform by using the third cantilever beam, the third cantilever beam and the first cantilever beam are located on a same plane, and the second fastening platform is electrically isolated from the rotating frame.

8. The actuating member according to claim 7, wherein the third fastening structure is electrically connected to the first fastening platform by using a through-silicon via TSV, and the rotating structure is electrically connected to the second fastening platform by using a TSV.

9. The actuating member according to any one of claims 1 to 3, wherein when the first comb is parallel to the second comb and the third comb is parallel to the fourth comb, the second comb is located above the first comb, and the fourth comb is located above the third comb.

10. The actuating member according to claim 9, wherein a third fastening platform is fastened to a surface that is of the rotating structure and that is close to the substrate, the third fastening platform is connected to the third fastening structure by using the third cantilever beam, the third cantilever beam and the first cantilever beam are located on a same plane, and the third fastening platform is electrically isolated from the rotating frame.

11. The actuating member according to claim 10, wherein the rotating structure is electrically connected to the third fastening platform by using a TSV.

12. The actuating member according to any one of claims 1 to 11, wherein the first fastening structure is electrically connected to a first electrode or is grounded, the second fastening structure is electrically connected to a second electrode, the third fastening structure is electrically connected to a third electrode, there is an electric potential difference between the first comb and the second comb, and there is an electric potential difference between the third comb and the fourth comb.

13. The actuating member according to claim 12, wherein the second electrode and the third electrode are located on a top surface of the substrate and are electrically isolated from the top surface of the substrate, the second electrode is electrically connected to the second fastening structure through wafer bonding, and the third electrode is electrically connected to the third fastening structure through wafer bonding.

14. The actuating member according to claim 12, wherein the second electrode and the third electrode are located on a bottom surface of the substrate, the second electrode is electrically connected to the second fastening structure by using a TSV, and the third electrode is electrically connected to the third fastening structure by using a TSV.

15. The actuating member according to claim 12, wherein the actuating member further comprises a coating structure, the coating structure covers the rotating frame, the rotating structure, and the rotating platform, the second electrode and the third electrode are located on a surface that is of the coating structure and that is away from the substrate, the second electrode is electrically connected to each second fastening structure by using a TSV, and the third electrode is electrically connected to each third fastening structure by using a TSV

16. The actuating member according to any one of claims 1 to 15, wherein the substrate comprises a cavity, and the rotating frame, the rotating structure, and the rotating platform are suspended above the cavity.

17. The actuating member according to claim 16, wherein a depth of the cavity is greater than maximum displacement of the rotating frame, the rotating platform, and the rotating structure in a direction perpendicular to the substrate during rotation.

18. The actuating member according to claim 16 or 17, wherein the actuating member further comprises a stop structure, the stop structure is fastened in the cavity, and a height of the stop structure is less than or equal to the depth of the cavity.

19. The actuating member according to any one of claims 1 to 18, wherein the actuating member further comprises a mass balance structure, and the mass balance structure is disposed on a surface that is of the rotating platform and that is close to the substrate.

20. The actuating member according to any one of claims 1 to 19, wherein the first cantilever beam is of a straight beam structure, an oblique beam structure, or a folded beam structure, the second cantilever beam is of a straight beam structure, an oblique beam structure, or a folded beam structure, and the third cantilever beam is of a straight beam structure, an oblique beam structure, or a folded beam structure.

21. The actuating member according to any one of claims 1 to 20, wherein the actuating member further comprises a reflective element and a support structure, the support structure is disposed on a surface that is of the rotating platform and that is away from the substrate, and the reflective element is disposed on the support structure.

22. The actuating member according to claim 21, wherein a reflective film is disposed on a surface of the reflective element.

23. The actuating member according to any one of claims 1 to 22, wherein the first fastening structure is a fastening frame, and the rotating frame is located at an inner side of the fastening frame.

24. The actuating member according to any one of claims 1 to 23, wherein materials of the first cantilever beam, the second cantilever beam, the third cantilever beam, the first comb, the second comb, the third comb, the fourth comb, the rotating frame, the rotating structure, the rotating platform, the first fastening structure, the second fastening structure, and the third fastening structure are made of any one of monocrystalline silicon, polycrystalline silicon, or amorphous silicon.

25. An actuating array, comprising: a coating structure and a plurality of actuating members according to any one of claims 1 to 24, wherein each actuating member is coated by the coating structure, and every two actuating members are separated by using the coating structure.

26. An actuating control system, comprising: a printed circuit board, a control chip, a connector, and the actuating member according to any one of claims 1 to 24, wherein the control chip, the connector, and the actuating member are fastened to the printed circuit board, and the control chip is connected to the actuating member by using the connector; and
the control chip is configured to output a control signal to the actuating member, to control the actuating member to rotate.

27. An actuating control system, comprising: a printed circuit board, a control chip, a connector, and the actuating array according to claim 25, wherein the control chip, the connector, and the actuating array are fastened to the printed circuit board, and the control chip is connected to the actuating array by using the connector; and
the control chip is configured to output a control signal to the actuating array, to control at least one actuating member in the actuating array to rotate.

28. A projection display system, comprising: an encoder, a controller, a light source, a light beam shaping apparatus, and the actuating member according to any one of claims 1 to 24, wherein the actuating member comprises a reflective element;
the encoder is configured to convert a to-be-projected graphic into a control signal, and output the control signal to the controller;
the controller controls, based on the control signal, the light source to output at least one light beam;
the light beam shaping apparatus is configured to perform beam shaping on the at least one light beam, and output at least one shaped light beam to the actuating member; and
the controller is further configured to control, based on the control signal, the actuating member to rotate, to project the at least one shaped light beam.

29. A projection display system, comprising: an encoder, a controller, a light source, a light beam shaping apparatus, and the actuating array according to claim 25, wherein each actuating member in the actuating array comprises a reflective element;
the encoder is configured to convert a to-be-projected graphic into a control signal, and output the control signal to the controller;
the controller controls, based on the control signal, the light source to output at least one light beam;
the light beam shaping apparatus is configured to perform beam shaping on the at least one light beam, and output at least one shaped light beam to the actuating array; and
the controller is further configured to control, based on the control signal, at least one actuating member in the actuating array to rotate, to project the at least one shaped light beam.

30. An optical cross connect OXC system, comprising: a controller, a first optical fiber array, a second optical fiber array, a first actuating array, and a second actuating array, wherein the first actuating array and the second actuating array are the actuating arrays according to claim 25, and each of actuating members in the first actuating array and the second actuating array comprises a reflective element;
the first optical fiber array is configured to couple at least one channel of light to the first actuating array;
the controller is configured to control at least one actuating member in the first actuating array to rotate, to reflect the at least one channel of light to the second actuating array; and
the controller is further configured to control at least one actuating member in the second actuating array to rotate, to couple the at least one channel of light to the second optical fiber array.

31. A spatial light-field regulation-control apparatus, comprising: a controller and the actuating array according to claim 25, wherein each of actuating members in the actuating array comprises a reflective element; and
the controller is configured to control a plurality of actuating members in the actuating array to rotate, to separately reflect light emitted into the actuating array to different locations in space.
